# EUROPÄISCHE PATENTANMELDUNG

(11) **EP 3 872 869 A1**
(43) Veröffentlichungstag der Anmeldung: **01.09.2021**
(21) Anmeldenummer: 21000048.5
(22) Anmeldetag: 15.02.2021
(51) Int. Cl.: H01L 31/0687, H01L 31/0304, H01L 29/885

(54) **STAPELFÖRMIGE MONOLITHISCHE AUFRECHT-METAMORPHE III-V-MEHRFACHSOLARZELLE**

(30) Priorität: 25.02.2020 DE 102020001185
(71) Anmelder: AZUR SPACE Solar Power GmbH, 74072 Heilbronn (DE)
(72) Erfinder: van Leest, Rosalinda, 4921 LE Made (NL)
(74) Vertreter: Koch Müller Patentanwaltsgesellschaft mbH

(57) **Zusammenfassung**

Stapelförmige monolithische Mehrfachsolarzelle aufweisend eine erste Teilzelle mit einer ersten Bandlücke und einer ersten Gitterkonstante, eine unter der ersten Teilzelle angeordnete zweite Teilzelle mit einer zweiten, größeren Bandlücke und einer zweiten Gitterkonstante, wobei zwischen der ersten und zweiten Teilzellen eine erste Tunneldiode mit einer p⁺-Schicht mit einer dritten Gitterkonstanten und einer n⁺-Schicht mit einer vierten Gitterkonstanten angeordnet ist, die zweite und vierte Gitterkonstante jeweils gleich der ersten Gitterkonstanten sind, die erste Teilzelle, die zweite Teilzelle und die erste Tunneldiode jeweils mindestens ein Element der III. Hauptgruppe und mindestens ein Element der V. Hauptgruppe aufweisen, die p⁺-Schicht (Ga)AlInAs aufweist oder aus (Ga)AlInAs besteht, die p⁺-Schicht bezogen auf die von der p⁺-Schicht umfassten Elemente der III. Hauptgruppe einen Gallium-Gehalt von kleiner als 10% aufweist, die dritte Gitterkonstante der p⁺-Schicht kleiner oder gleich der Gitterkonstanten der ersten Teilzelle ist.

## Beschreibung

Die Erfindung betrifft eine stapelförmige, monolithische, aufrechtmetamorphe III-V-Mehrfachsolarzelle.

Aus W. Guter et al, "Investigation and development of III-V-triple-junction concentrator solar cells", in 22nd European Photovoltaic Solar Energy Conference, 3-7 September 2007, Milan Italy, S.122-125 Ist ein monolithischer, aufrecht-metamorpher Solarzellenstapel bekannt, wobei die Teilzellen mittels gitterangepasster AIGaInAs basierter Tunneldioden verbunden sind.

Aus der DE 10 2017 005 950 A1 ist eine stapelförmige monolithische III-V-Mehrfachsolarzelle mit einer Tunneldiode mit in Summe gegenüber den benachbarten Solarzellen verspannter Schichtfolge bekannt.

Aus der EP 2 251 912 A1 ist eine stapelförmige, monolithische III-V-Mehrfachsolarzelle mit verbesserter Stromleitung zwischen den Solarzellen bekannt. Hierzu wird zwischen zwei aufeinanderfolgenden Solarzellen eine Tunneldiode mit zueinander verspannten entarteten Schichten angeordnet.

Aus der WO 2010 / 151 553 A1 ist eine Tunneldiode mit einer Zwischenschicht bekannt, wobei die Zwischenschicht aus einer Verbindung eines Metalls der Seltenen Erden mit einem Element der V. Hautgruppe, z.B. aus ErAs, besteht. Mittels der Zwischenschicht werden negative Einflüsse einer Wärmebehandlung auf die Tunneldiode unterdrückt und ermöglicht hierdurch die Integration von Nitrid in folgende Teilzellen.

Verschiedene weitere Tunneldioden für Mehrfachsolarzellenstapel sind aus der US 2015 / 0 333 214 A1, der US 2012 / 0 125 392 A1, der US 2014 / 0 076 386 A1, der US 2010 / 0 229 930 A1, der US 2015 / 0 034 153 A1 und der CN 101 976 689 A bekannt.

Vor diesem Hintergrund besteht die Aufgabe der Erfindung darin, eine Vorrichtung anzugeben, die den Stand der Technik weiterbildet.

Die Aufgabe wird durch eine III-V-Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige monolithische Mehrfachsolarzelle bereitgestellt, aufweisend eine erste Teilzelle mit einer ersten Bandlücke und einer ersten Gitterkonstante und eine unter der ersten Teilzelle angeordnete zweite Teilzelle mit einer zweiten Bandlücke und einer zweiten Gitterkonstante.

Die erste Bandlücke ist größer als die zweite Bandlücke.

Zwischen der ersten Teilzelle und der zweiten Teilzelle ist eine erste Tunneldiode angeordnet, wobei die erste Tunneldiode eine p⁺-Schicht mit einer dritten Gitterkonstanten und eine n⁺-Schicht mit einer vierten Gitterkonstanten aufweist.

Die zweite Gitterkonstante und die vierte Gitterkonstante sind jeweils gleich der ersten Gitterkonstanten oder weichen bezogen auf die erste Gitterkonstante um höchstens 0,5% von der ersten Gitterkonstanten ab.

Die erste Teilzelle, die zweite Teilzelle und die erste Tunneldiode weisen jeweils mindestens ein Element der III. Hauptgruppe und mindestens ein Element der V. Hauptgruppe auf.

Die p⁺-Schicht weist AlInAs oder (Ga)AlInAs auf oder besteht aus AlInAs oder (Ga)AlInAs, wobei die p⁺-Schicht bezogen auf die von der p⁺-Schicht umfassten Elemente der III. Hauptgruppe einen Gallium-Gehalt von kleiner als 10% aufweist.

Die dritte Gitterkonstante der p⁺-Schicht ist kleiner oder bis auf eine Abweichung von höchstens 0,5% bezogen auf die erste Gitterkonstante gleich der Gitterkonstanten der ersten Teilzelle.

Bei sich gleichenden Gitterkonstanten bzw. einer Abweichung von höchstens 0,5% spricht man auch von zueinander gitterangepassten Schichten. Eine Abweichung um mehr als 0,5% wird dagegen als gitterunangepasst oder als Gitterfehlanpassung bezeichnet.

Die erste und zweite Teilzelle sowie die n+-Schicht der Tunneldiode sind somit zueinander gitterangepasst ausgeführt, während die p+-Schicht der Tunneldiode entweder ebenfalls gitterangepasst zu den vorgenannten Schichten ausgeführt ist oder in einer anderen Ausführungsform fehlangepasst zu den vorgenannten Schichten ausgebildet ist.

Es versteht sich, dass der Begriff der Teilzelle synonym mit dem Begriff der Teilsolarzelle verwendet wird. Anders ausgedrückt besteht der Solarzellenstapel aus mehreren Teilsolarzellen, die miteinander mittels Tunneldioden in Serie verschaltet sind.

Weiter versteht es sich, dass die Mehrfachsolarzelle gemäß weiterer Ausführungsformen weitere Teilzellen unterhalb der ersten und zweiten Teilzelle aufweist, wobei die Mehrfachsolarzelle für einen Lichteinfall auf die oberste Teilzelle, also auf die erste Teilzelle, ausgelegt ist.

Anders ausgedrückt, das Licht durchdringt zuerst die erste Teilzelle und anschließend die zweite Teilzelle sowie gegebenenfalls weitere Teilzellen, wenn vorhanden.

Alle Schichten sind epitaktisch, z.B. mittels MOVPE hergestellt und / oder durch einen Waferbond miteinander verbunden.

Es versteht sich, dass "bestehen aus" hinsichtlich einer Schicht nicht ausschließt, dass die Schicht zusätzlich zu der angeführten Materialkomposition auch weitere Stoffe, wie Dotierstoffe, z.B. Zink oder Kohlenstoff oder Silizium oder Tellur, oder auch durch den Herstellungsprozess bedingte Verunreinigungen aufweist.

In einer Ausführungsform sind die Teilzellen jeweils als n über p- Struktur ausgebildet, wobei die p-Basisschicht eine größere Schichtdicke als die n-Emitterschicht aufweist. Die Tunneldioden weisen entsprechend eine Schichtfolge mit p über n auf.

Untersuchungen haben gezeigt, dass aufgrund des hohen Aluminium-Gehalts mit der beanspruchten Materialzusammensetzung der Tunneldiode eine besonders hohe Transparenz erreicht wird. Überraschender Weise wird außerdem nicht nur eine hohe Stromtragfähigkeit, sondern auch ein stabiles Aufwachsen der mindestens einen folgenden Solarzelle mit hoher Qualität sicherstellt.

Des Weiteren zeigt sich überraschenderweise, dass sich die p+ Schicht der Tunneldiode mit einer Dotierung von größer als 8• 10¹⁸ cm⁻³ trotz eines hohen Indium Gehalts von über 10% bezogen auf die Elemente der III-Hauptgruppe herstellen lässt. Besonders überraschend wird trotz der hohen Dotierung der p+ Schicht und gleichzeitig hohem Indium Gehalt, eine hohe Schichtqualität der p+ Schicht erreicht, wodurch wiederum auch eine hohe Schichtqualität der Schichten der darauffolgenden Solarzelle erreicht wird.

Der hohe Indium-Gehalt es ermöglicht außerdem die p+ Schicht der Tunneldiode gitterangepasst herzustellen.

Durch die hohe Dotierung und gegebenenfalls eine gitterangepasste Ausführung auch der p+-Schicht der Tunneldiode wird eine Steigerung der Effizienz erreicht und die Ausbeute bei der Herstellung gesteigert.

Ein Vorteil der erfindungsgemäßen Mehrfachsolarzelle ist daher eine hohe Qualität bei vertretbaren Herstellungskosten.

In einer Ausführungsform weist die erste Tunneldiode eine zwischen der p⁺-Schicht und der n⁺-Schicht ausgebildete Zwischenschicht auf, wobei die Zwischenschicht eine Schichtdicke zwischen 0,5 nm und 5 nm und eine n-Dotierstoffkonzentration von mindestens 1•10¹⁸ cm⁻³, z.B. mit Silizium als Dotierstoff, aufweist.

In einer weiteren Ausführungsform weist die p+-Schicht eine Dotierung mit dem Element Kohlenstoff und einer Dotierstoffkonzentration größer 8•10¹⁸ cm⁻³ oder größer als 1•10¹⁹ cm⁻³ oder größer als 2•10¹⁹ cm⁻³ oder größer als 3•10¹⁹ cm⁻³ oder größer als 4•10¹⁹ cm⁻³ oder größer als 5•10¹⁹ cm⁻³ auf.

In einer anderen Ausführungsform weist die Mehrfachsolarzelle eine unter der zweiten Teilzelle angeordnete dritte Teilzelle mit einer dritten Bandlücke und einer fünften Gitterkonstante auf, wobei die dritte Bandlücke kleiner als die zweite Bandlücke ist und zwischen der zweiten Teilzelle und der dritten Teilzelle eine zweite Tunneldiode angeordnet ist.

In einer ersten alternativen Ausführungsform ist die fünfte Gitterkonstante gleich der ersten Gitterkonstanten oder weicht bezogen auf die erste Gitterkonstante um höchstens 0,5% von der ersten Gitterkonstanten ab.

In der zweiten alternativen Ausführungsform weicht die fünfte Gitterkonstante von der ersten Gitterkonstanten ab, wobei zwischen der dritten Teilzelle und der zweiten Teilzelle oberhalb oder unterhalb der zweiten Tunneldiode ein metamorpher Puffer angeordnet ist.

In einer Weiterbildung ist unterhalb des metamorphen Puffers nur eine einzige Teilzelle ausbildet.

In einer weiteren Weiterbildung umfasst die Teilzelle unterhalb des metamorphen Puffers Germanium oder besteht aus Germanium. Hierbei ist die Ge-Teilzelle beispielsweise als Substrat-Teilzelle ausgebildet.

Als metamorpher Puffer wird eine Schichtfolge mit sich über die Höhe des Puffers ändernder Gitterkonstanten verstanden. Die Schichtfolge des Puffers gleicht Gitterkonstantenunterschiede zwischen zwei Schichten aus und minimiert insbesondere Gitterfehler, wie fadenförmige Versetzungen, in den gitterunangepassten Schichten.

Es versteht sich, dass sich die Gitterkonstanten der Tunneldiodenschichten nach der Position der Tunneldiodenschichten, also der Positionierung oberhalb oder unterhalb des Puffers, richten bzw. entsprechend angepasst werden.

Des Weiteren sei angemerkt, dass der metamorphe Puffer vorzugsweise eine Abfolge von mindestens drei Schichten umfasst, wobei jede Schicht eine Gitterkonstante aufweist und die Gitterkonstanten der Schichten in Richtung der zweiten Teilzelle von Schicht zu Schicht ansteigt.

Alternativ weist der metamorphe Puffer zwischen einer unteren Schicht und einer oberen Schicht eine nahezu lineare Änderung der Gitterkonstanten und / oder der Dotierung auf.

In einer weiteren Ausführungsform ist die zweite Tunneldiode wie die erste Tunneldiode ausgebildet und weist gemäß einer Weiterbildung eine vorbeschriebene Zwischenschicht auf.

In einer anderen Ausführungsform weist die dritte Teilzelle Germanium auf oder besteht aus Germanium und/oder die zweite Teilzelle weist InGaAs auf oder besteht aus InGaAs und/oder die erste Teilzelle weist (Al)InGaP auf oder besteht aus AlInGaP oder InGaP.

In einer weiteren Weiterbildung weist die Mehrfachsolarzelle eine unter der dritten Teilzelle angeordnete vierte Teilzelle mit einer vierten Bandlücke und einer sechsten Gitterkonstante auf, wobei die vierte Bandlücke kleiner als die dritte Bandlücke ist und zwischen der dritten Teilzelle und der vierten Teilzelle eine dritte Tunneldiode angeordnet ist.

In einer ersten Ausführungsform ist die sechste Gitterkonstante gleich der ersten Gitterkonstanten oder weicht um höchstens 0,5% ab. Alternativ weicht die sechste Gitterkonstante von der ersten Gitterkonstanten ab, wobei zwischen der vierten Teilzelle und der dritten Teilzelle ein metamorpher Puffer angeordnet ist.

In einer anderen Weiterbildung ist die dritte Tunneldiode wie die erste Tunneldiode ausgebildet und weist in einer Weiterbildung eine Zwischenschicht wie vorbeschrieben auf.

In einer anderen Ausführungsform weist die vierte Teilzelle Germanium auf oder besteht aus Germanium, wobei zusätzlich oder alternativ die dritte Teilzelle InGaAs aufweist oder aus InGaAs besteht und/oder die zweite Teilzelle (Al)(In)GaAs aufweist oder aus GaAs oder InGaAs oder aus AlGaAs oder aus AlInGaAs besteht und/oder die erste Teilzelle (Al)InGaP aufweist oder als AlInGaP oder InGaP besteht.

In einer weiteren Weiterbildung weist die Mehrfachsolarzelle eine unter der vierten Teilzelle angeordnete fünfte Teilzelle mit einer fünften Bandlücke und einer siebten Gitterkonstante auf, wobei die fünfte Bandlücke kleiner als die vierte Bandlücke ist und zwischen der vierten Teilzelle und der fünften Teilzelle eine vierte Tunneldiode angeordnet ist.

In einer Ausführungsform ist die siebte Gitterkonstante gleich der ersten Gitterkonstanten oder weicht um höchstens 0,5% ab. Alternativ weicht die siebte Gitterkonstante von der ersten Gitterkonstanten ab, wobei zwischen der fünften Teilzelle und der vierten Teilzelle oberhalb oder unterhalb der vierten Tunneldiode ein metamorpher Puffer angeordnet ist.

In einer weiteren Ausführungsform weist die fünfte Teilzelle Germanium auf oder besteht aus Germanium, wobei zusätzlich oder alternativ die vierte Teilzelle +GaInAs aufweist oder aus GaInAs besteht und/oder die dritte Teilzelle AlInGaAs aufweist oder aus AlInGaAs besteht und/oder die zweite Teilzelle GaInP aufweist oder aus GaInP besteht und/oder die erste Teilzelle (Al)InGaP aufweist oder als AlInGaP oder InGaP besteht.

Es versteht sich, dass sich Germanium aufgrund der geringen Bandlücke besonders als unterste Teilzelle der Mehrfachsolarzelle eignet. Mittels eines metamorphen Puffers lassen sich auf die Germaniumzelle mehrere III-V Teilzellen ohne Gitteranpassung zu Germanium aufzuwachsen. Es zeigte sich, dass sich trotz des metamorphen Puffers, d.h. trotz der Gitterfehlanpassung der Germaniumzelle zu den weiteren auf dem metamorphen Puffer aufliegenden Teilzellen, bei der Herstellung der Mehrfachsolarzelle eine hohe Ausbeute einstellt. Außerdem wird eine hohe Konversionseffizenz aufgrund der hohen Schichtqualität der aufliegenden Teilzellen erreicht.

In einer anderen Weiterbildung weist die n+-Schicht bezogen auf die von der n+-Schicht umfassten Elemente der III. Hauptgruppe einen Indium-Gehalt größer als 60% auf und eine Dotierung von mindestens 1•10¹⁹ cm⁻³ oder mindestens 3•10¹⁹ cm⁻³ oder mindestens 5•10¹⁹ cm⁻³ auf. Vorzugsweise umfasst die n+-Schicht InGaP oder AlInGaP oder InAlP oder besteht aus InGaP oder AlInGaP oder InAlP.

In einer anderen Weiterbildung weist die n+-Schicht bezogen auf die von der n+-Schicht umfassten Elemente der III. Hauptgruppe einen Indium-Gehalt größer als 60% auf und eine Dotierung von mindestens 1•10¹⁹ cm⁻³ oder mindestens 3•10¹⁹ cm⁻³ oder mindestens 5•10¹⁹ cm⁻³ auf, wobei die n+-Schicht InGaP oder InGaAs oder AlInGaP oder InAlP umfasst oder aus InGaP oder AlInGaP oder InAlP oder InGaAs besteht.

In einer anderen Weiterbildung weist die n+-Schicht bezogen auf die von der n+-Schicht umfassten Elemente der III. Hauptgruppe einen Indium-Gehalt kleiner als 50% auf und eine Dotierung von mindestens 1•10¹⁹ cm⁻³ oder mindestens 3•10¹⁹ cm⁻³ oder mindestens 5•10¹⁹ cm⁻³ auf, wobei die n+-Schicht InGaAs oder GaAs umfasst oder aus InGaAs oder GaAs besteht.

In einer Ausführungsform weist die p+-Schicht bezogen auf die von der p+-Schicht umfassten Elemente der III. Hauptgruppe einen Indium-Gehalt größer als 7% oder größer als 10 % auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht einer ersten Ausführungsform einer Mehrfachsolarzelle,
- Figur 2: eine Ansicht einer zweiten Ausführungsform der Mehrfachsolarzelle,
- Figur 3: eine Ansicht einer dritten Ausführungsform der Mehrfachsolarzelle,
- Figur 4: eine Ansicht einer vierten Ausführungsform der Mehrfachsolarzelle,
- Figur 5: eine Ansicht einer fünften Ausführungsform der Mehrfachsolarzelle
- Figur 6: eine Ansicht einer sechsten Ausführungsform der Mehrfachsolarzelle,
- Figur 7: eine Ansicht einer siebten Ausführungsform der Mehrfachsolarzelle,
- Figur 8: eine Ansicht einer achten Ausführungsform der Mehrfachsolarzelle,
- Figur 9: eine Ansicht einer neunte Ausführungsform der Mehrfachsolarzelle.
Die Abbildung der Figur 1 zeigt eine erste Ausführungsform einer Mehrfachsolarzelle.

Die stapelförmige monolithische Mehrfachsolarzelle weist als obere Teilzelle eine erste Teilzelle SC1 mit einer ersten Bandlücke EG1 und einer ersten Gitterkonstanten A1, eine ersten Tunneldiode TD1 und eine zweite Teilzelle SC2 mit einer zweiten Bandlücke EG2 und einer der ersten Gitterkonstanten A1 entsprechenden zweiten Gitterkonstanten A2 als untere Teilzelle auf.

Die erste Tunneldiode TD1 weist eine n+-Schicht und eine p+-Schicht auf. Die n+-Schicht weist bezogen auf die in der Schicht enthaltenen Elemente der III. Hauptgruppe einen Indium-Gehalt größer als 60% auf und besteht beispielsweise aus InAlP oder aus (Al)InGaP oder weist InAlP oder (Al)InGaP auf.

Die p+-Schicht besteht aus (Ga)AlInAs oder weist (Ga)AlInAs auf, wobei ein Gallium-Gehalt der p+-Schicht der bezogen auf die in der Schicht enthaltenen Elemente der III. Hauptgruppe kleiner 10% beträgt.

Die zweite Teilzelle SC2 und die n+-Schicht sind jeweils gitterangepasst zu der ersten Teilzelle SC1 ausgebildet, d.h. die zweite Gitterkonstante sowie eine vierte Gitterkonstant A4 der n+-Schicht sind jeweils gleich der ersten Gitterkonstanten A1 oder weichen von der ersten Gitterkonstanten A1 um höchstens 0,5% ab.

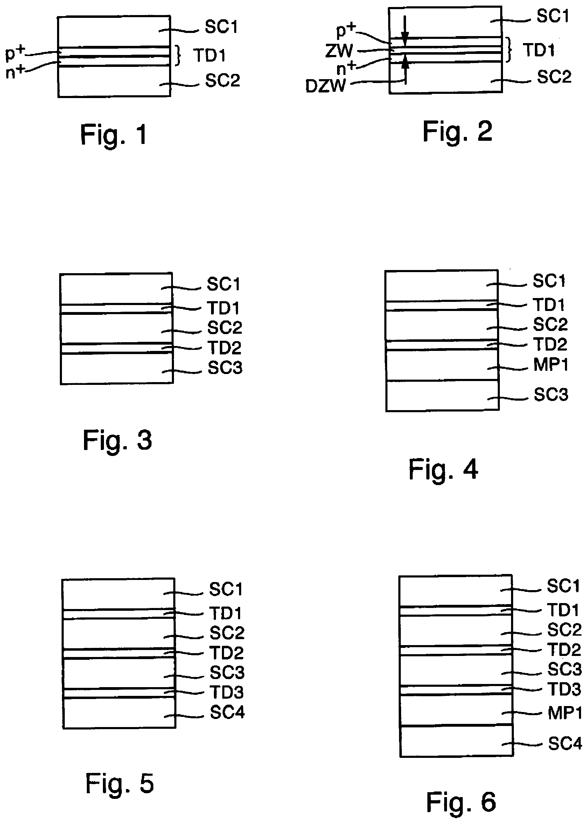

In der Abbildung der Figur 2 ist eine weitere Ausführungsform dargestellt. Im Folgenden werden nur die Unterschiede zu der Abbildung der Figur 1 erläutert.

Die erste Tunneldiode TD1 weist zwischen der n+-Schicht und der p+-Schicht eine Zwischenschicht ZW auf, wobei die Zwischenschicht eine Schichtdicke DZW zwischen 0,5 nm und 5 nm und eine n-Dotierstoffkonzentration von mindestens 1•10¹⁸ cm⁻³ mit Silizium als Dotierstoff aufweist.

In der Abbildung der Figur 3 ist eine weitere Ausführungsform dargestellt. Im Folgenden werden nur die Unterschiede zu den Abbildungen der Figuren 1 und 2 erläutert.

Die dargestellte Mehrfachsolarzelle ist als gitterangepasste Dreifach-Solarzelle ausgebildet, wobei eine dritte Teilzelle SC3 gitterangepasst zu der ersten und zweiten Teilzelle SC1 und SC2 ausgebildet ist. Zwischen der dritten Teilzelle SC3 und der zweiten Teilzelle SC2 ist eine zweite Tunneldiode TD2 angeordnet.

Gemäß einer Weiterbildung weist die zweite Tunneldiode TD2 dieselben Eigenschaften wie die erste Tunneldiode auf.

In der Abbildung der Figur 4 ist eine weitere Ausführungsform dargestellt. Im Folgenden werden nur die Unterschiede zu der Abbildung der Figur 3 erläutert.

Die dritte Teilzelle SC3 weist eine von der ersten Gitterkonstanten A1 abweichende fünfte Gitterkonstante A5 auf. Die Mehrfachsolarzelle ist also als metamorphe dreifach-Solarzelle ausgebildet.

Als Ausgleich für die Abweichung weist die Mehrfachsolarzelle einen zwischen der dritten Teilzelle SC3 und der zweiten Tunneldiode angeordneten metamorphen Puffer MP1 auf.

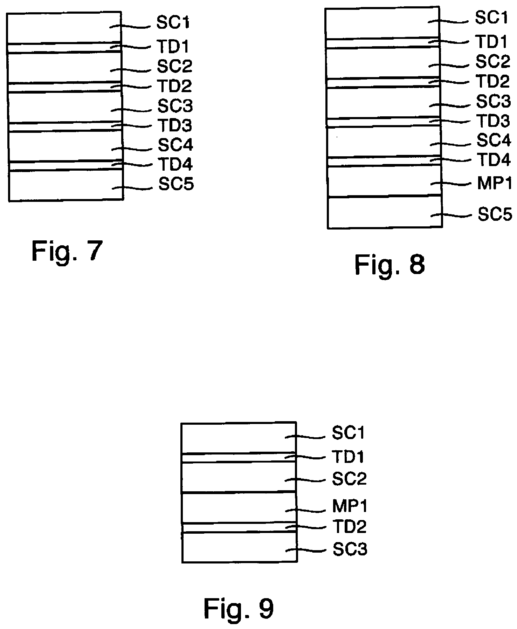

In einer anderen alternativen Ausführungsform ist die zweite Tunneldiode TD2 gitterangepasst zu der dritten Teilzelle SC3 ausgebildet und der Puffer ist zwischen der zweiten Tunneldioden TD2 und der zweiten Teilzelle SC2 angeordnet. Diese Ausführungsvariante ist in Figur 9 dargestellt.

In der Abbildung der Figur 5 ist eine weitere Ausführungsform dargestellt. Im Folgenden werden nur die Unterschiede zu der Abbildung der Figur 3 erläutert.

Die dargestellte Mehrfachsolarzelle ist als gitterangepasste vierfach-Solarzelle ausgebildet, weist also eine unterhalb der dritten Teilzelle SC3 angeordnete vierte Teilzelle SC4 mit einer der ersten Gitterkonstanten entsprechenden sechsten Gitterkonstanten A6 sowie eine zwischen der vierten Teilzelle SC4 und der dritten Teilzelle SC3 angeordnete dritte Tunneldiode TD3 auf.

In einer anderen Weiterbildung weisen die dritte Tunneldiode TD3 und/oder die zweite Tunneldiode TD2 dieselben Eigenschaften wie die erste Tunneldiode TD1 auf.

In der Abbildung der Figur 6 ist eine weitere Ausführungsform dargestellt. Im Folgenden werden nur die Unterschiede zu der Abbildung der Figur 5 erläutert.

Die sechste Gitterkonstante A6 der vierten Teilzelle SC4 weicht von der ersten Gitterkonstanten A1 ab. Als Ausgleich für die Abweichung weist die Mehrfachsolarzelle einen zwischen der vierten Teilzelle SC4 und der dritten Tunneldiode TD3 angeordneten metamorphen Puffer MP1 auf.

In einer anderen nicht dargestellten alternativen Ausführungsform ist die dritte Tunneldiode TD3 gitterangepasst zu der vierten Teilzelle SC4 ausgebildet und der Puffer ist zwischen der dritten Tunneldioden TD3 und der dritten Teilzelle SC3 angeordnet.

In der Abbildung der Figur 7 ist eine weitere Ausführungsform dargestellt. Im Folgenden werden nur die Unterschiede zu der Abbildung der Figur 5 erläutert.

Die dargestellte Mehrfachsolarzelle ist als gitterangepasste fünffach-Solarzelle ausgebildet und weist eine unterhalb der vierten Teilzelle SC4 angeordnete fünfte Teilzelle SC5 mit einer der ersten Gitterkonstanten A1 entsprechenden siebten Gitterkonstanten und eine zwischen der vierten Teilzelle SC4 und der fünften Teilzelle SC5 angeordnete fünfte Tunneldiode TD5 auf.

In der Abbildung der Figur 8 ist eine weitere Ausführungsform dargestellt. Im Folgenden werden nur die Unterschiede zu der Abbildung der Figur 7 erläutert.

Die Mehrfachsolarzelle ist als metamorphe fünffach-Solarzelle mit einem metamorphen Puffer MP1 zwischen der fünften Teilzelle SC5 und der vierten Tunneldiode TD4 ausgebildet, um eine Abweichung der siebten Gitterkonstante A7 der fünften Teilzelle SC5 von der ersten Gitterkonstanten A1 auszugleichen.

In einer anderen Weiterbildung weisen die dritte Tunneldiode TD3 und/oder die zweite Tunneldiode TD2 und/oder die vierte Tunneldiode TD4 dieselben Eigenschaften wie die erste Tunneldiode TD1 auf.

In einer nicht dargestellten Ausführungsform sind die Positionen des metamorphen Puffers MP1 und der vierten Tunneldiode TD4 entsprechend dem Ausführungsbeispiel der Figur 9 vertauscht.

## Patentansprüche

1. Stapelförmige monolithische Mehrfachsolarzelle (S) aufweisend
- eine erste Teilzelle (SC1) mit einer ersten Bandlücke (EG1) und einer ersten Gitterkonstante (A1),
- eine unter der ersten Teilzelle (SC1) angeordnete zweite Teilzelle (SC2) mit einer zweiten Bandlücke (EG2) und einer zweiten Gitterkonstante (A2), wobei
- die erste Bandlücke (EG1) größer ist als die zweite Bandlücke (EG2) ist,
- zwischen der ersten Teilzelle (SC1) und der zweiten Teilzellen (SC2) eine erste Tunneldiode (TD1) mit einer p⁺-Schicht mit einer dritten Gitterkonstanten (A3) und einer n⁺-Schicht mit einer vierten Gitterkonstanten (A4) angeordnet ist,
- die zweite Gitterkonstante (A2) und die vierte Gitterkonstante (A4) jeweils gleich der ersten Gitterkonstanten (A1) sind oder bezogen auf die erste Gitterkonstante (A1) um höchstens 0,5% von der ersten Gitterkonstanten (A1) abweichen, und
- die erste Teilzelle (SC1), die zweite Teilzelle (SC2) und die erste Tunneldiode (TD1) jeweils mindestens ein Element der III. Hauptgruppe und mindestens ein Element der V. Hauptgruppe aufweisen, **dadurch gekennzeichnet, dass**
- die p⁺-Schicht AlInAs aufweist oder aus AlInAs besteht,
- die dritte Gitterkonstante (A3) der p⁺-Schicht bis auf eine Abweichung von höchstens 0,5% bezogen auf die erste Gitterkonstante gleich der ersten Gitterkonstanten (A1) der ersten Teilzelle (SC1) ist,
- die p+ Schicht eine Dotierung mit dem Element Kohlenstoff und einer Dotierstoffkonzentration größer als 8•10¹⁸ cm⁻³ oder größer als 1•10¹⁹ cm⁻³ oder größer als 2•10¹⁹ cm⁻³ oder größer als 3•10¹⁹ cm⁻³ oder größer als 4•10¹⁹ cm⁻³ oder größer als 5•10¹⁹ cm⁻³ aufweist,
- die n⁺-Schicht bezogen auf die von der n⁺-Schicht umfassten Elemente der III. Hauptgruppe einen Indium-Gehalt größer als 60% aufweist und eine Dotierung von mindestens 1•10¹⁹ cm⁻³ oder mindestens 3•10¹⁹ cm⁻³ oder mindestens 5•10¹⁹ cm⁻³ aufweist und die n⁺-Schicht InAlP umfasst oder aus InAlP besteht.

2. Mehrfachsolarzelle nach Anspruch 1, **dadurch gekennzeichnet, dass** die erste Tunneldiode (TD1) eine zwischen der p⁺-Schicht und der n⁺-Schicht ausgebildete Zwischenschicht (ZW) aufweist, wobei die Zwischenschicht (ZW) eine Schichtdicke(DZW) zwischen 0,5 nm und 5 nm und eine n-Dotierstoffkonzentration von mindestens 1•10¹⁸ cm⁻³ aufweist.

3. Mehrfachsolarzelle nach einem der vorangegangenen Ansprüche, **dadurch gekennzeichnet, dass** die Mehrfachsolarzelle eine unter der zweiten Teilzelle (SC2) angeordnete dritte Teilzelle (SC3) mit einer dritten Bandlücke (EG3) und einer fünften Gitterkonstante (A5) aufweist, wobei die dritte Bandlücke (EG3) kleiner als die zweite Bandlücke (EG2) ist und zwischen der zweiten Teilzelle (SC2) und der dritten Teilzelle (SC3) eine zweite Tunneldiode (TD2) angeordnet ist.

4. Mehrfachsolarzelle nach Anspruch 3, **dadurch gekennzeichnet, dass** die fünfte Gitterkonstante (A5) gleich der ersten Gitterkonstanten (A1) ist oder bezogen auf die erste Gitterkonstante (A1) um höchstens 0,5% von der ersten Gitterkonstante (A1) abweicht.

5. Mehrfachsolarzelle nach Anspruch 3, **dadurch gekennzeichnet, dass** die fünfte Gitterkonstante (A5) von der ersten Gitterkonstanten (A1) abweicht, wobei zwischen der dritten Teilzelle (SC3) und der zweiten Teilzelle (SC2) oberhalb oder unterhalb der zweiten Tunneldiode (TD2) ein metamorpher Puffer (MP1) angeordnet ist.

6. Mehrfachsolarzelle nach einem der Ansprüche 4 bis 9, **dadurch gekennzeichnet, dass** die Mehrfachsolarzelle eine unter der dritten Teilzelle (SC3) angeordnete vierte Teilzelle (SC4) mit einer vierten Bandlücke (EG4) und einer sechsten Gitterkonstante (A6) aufweist, wobei die vierte Bandlücke (EG4) kleiner als die dritte Bandlücke (EG3) ist und zwischen der dritten Teilzelle (SC3) und der vierten Teilzelle (SC4) eine dritte Tunneldiode (TD3) angeordnet ist.

7. Mehrfachsolarzelle nach Anspruch 6, **dadurch gekennzeichnet, dass** die sechste Gitterkonstante (A6) gleich der ersten Gitterkonstanten (A1) ist oder um höchstens 0,5% abweicht.

8. Mehrfachsolarzelle nach Anspruch 6, **dadurch gekennzeichnet, dass** die sechste Gitterkonstante (A6) von der ersten Gitterkonstanten (A1) abweicht, wobei zwischen der vierten Teilzelle (SC4) und der dritten Teilzelle (SC3) oberhalb oder unterhalb der dritten Tunneldiode (TD3) ein metamorpher Puffer (MP1) angeordnet ist.

9. Mehrfachsolarzelle nach einem der Ansprüche 6 bis 8, **dadurch gekennzeichnet, dass** die vierte Teilzelle (SC4) Germanium aufweist oder aus Germanium besteht und/oder die dritte Teilzelle (SC3) InGaAs aufweist oder aus InGaAs besteht und/oder die zweite Teilzelle (SC2) (Al)(In)GaAs aufweist oder aus GaAs oder InGaAs oder aus AlGaAs oder aus AlInGaAs besteht und/oder die erste Teilzelle (SC1) (Al)InGaP aufweist oder als AlInGaP oder InGaP besteht.

10. Mehrfachsolarzelle nach einem der Ansprüche 6 bis 9, **dadurch gekennzeichnet, dass** die Mehrfachsolarzelle eine unter der vierten Teilzelle (SC4) angeordnete fünfte Teilzelle (SC3) mit einer fünften Bandlücke (EG5) und einer siebten Gitterkonstante (A7) aufweist, wobei die fünfte Bandlücke (EG5) kleiner als die vierte Bandlücke (EG4) ist und zwischen der vierten Teilzelle (SC4) und der fünften Teilzelle (SC5) eine vierte Tunneldiode (TD4) angeordnet ist.

11. Mehrfachsolarzelle nach Anspruch 10, **dadurch gekennzeichnet, dass** die siebte Gitterkonstante (A7) gleich der ersten Gitterkonstanten (A1) ist oder um höchstens 0,5% abweicht.

12. Mehrfachsolarzelle nach Anspruch 11, **dadurch gekennzeichnet, dass** die siebte Gitterkonstante (A7) von der ersten Gitterkonstanten (A1) abweicht, wobei zwischen der fünften Teilzelle (SC5) und der vierten Teilzelle (SC4) oberhalb oder unterhalb der vierten Tunneldiode (TD4) ein metamorpher Puffer (MP1) angeordnet ist.

13. Mehrfachsolarzelle nach Anspruch 12, **dadurch gekennzeichnet, dass** die fünfte Teilzelle (SC5) Germanium aufweist oder aus Germanium besteht und/oder die vierte Teilzelle (SC4) GaInAs aufweist oder aus GaInAs besteht und/oder die dritte Teilzelle (SC3) AlInGaAs aufweist oder aus AlInGaAs besteht und/oder die zweite Teilzelle (SC2) GaInP aufweist oder aus GaInP besteht und/oder die erste Teilzelle (SC1) (Al)InGaP aufweist oder als AlInGaP oder InGaP besteht.

14. Mehrfachsolarzelle nach einem der vorangegangenen Ansprüche, **dadurch gekennzeichnet, dass** die p⁺-Schicht bezogen auf die von der p⁺-Schicht umfassten Elemente der III. Hauptgruppe einen Indium-Gehalt größer als 7% oder größer als 10 % aufweist.
